# EUROPEAN PATENT APPLICATION

(11) **EP 2 128 685 A1**
(43) Date of publication of application: **02.12.2009**
(21) Application number: 09159481.2
(22) Date of filing: 06.05.2009
(51) Int. Cl.: G02F 1/13

(54) **Liquid crystal display apparatus and method for manufacturing liquid crystal display apparatus**

(30) Priority: 09.05.2008 JP 2008122877
(71) Applicant: Funai Electric Co., Ltd., Osaka 574-0013 (JP)
(72) Inventor: Yamanaka, Yusaku, Daito-shi Osaka 574-0013 (JP)
(74) Representative: Grünecker, Kinkeldey, Stockmair & Schwanhäusser Anwaltssozietät

(57) **Abstract**

A liquid crystal display apparatus includes a liquid crystal panel (1) with electrodes (11) and a COF substrate (2) with a positioning electrode (21b) whose shape differs from the shape of the other COF electrodes (21a). When one end portion (211) in a width direction of the positioning electrode (21b) and one end portion (111) in a width direction of one electrode (11) in the electrode portion are aligned, the centers of the other COF electrodes the electrodes (11) of the panel are substantially aligned. The COF electrodes (21a) have widths (d) different from the widths (b) of the electrodes of the panel (1).

## Description

### BACKGROUND OF THE INVENTION

### Field of the Invention

The present invention relates to a liquid crystal display apparatus and a method for manufacturing the liquid crystal display apparatus.

### Description of Related Art

A COF (Chip On Film) is used in a liquid crystal display apparatus to connect a liquid crystal panel and a printed circuit board (PCB) that supplies a drive signal to the liquid crystal panel.

This COF substrate is mounted by passing through a steps of superposing COF electrodes arrayed in a row at constant intervals on electrodes of liquid crystal cells arrayed on the liquid crystal panel in a row similar to that of the COF electrodes, and then bonding the electrodes together by thermo compression with an anisotropic conductive film (ACF) inserted therebetween.

With regard to the above mounting of the COF, for example, Japanese Patent Application Laid-Open No. 2000-111939 proposes a liquid crystal display element in which a wiring pattern is formed depending on areas of the electrodes so that contact areas of the electrodes of a semiconductor chip and the wiring pattern become equal to cope with a problem that contact defects occur between each of the electrodes of the COF and the wiring pattern because the areas of the electrodes are not constant.

In addition, alternatively, Japanese Patent Application Laid-Open Nos. 2001-255550 and 2000-312070 propose techniques for preventing the misalignment between terminals that is caused by thermal expansion during compression.

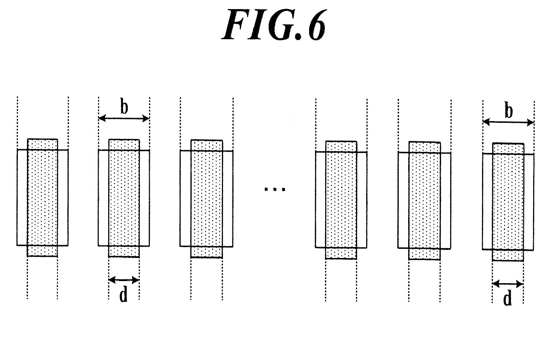

When superposition of the electrodes on the liquid crystal panel and the COF electrodes is performed, as shown in Fig. 6, in the case that electrode widths b of the electrodes of the liquid crystal panel and the electrode widths d of the COF electrodes are different, end portions in a width direction of both electrodes do not align. Thus, fine adjustments are necessary in order to align correctly a center in a width direction of the COF electrodes and a center in a width direction of the electrodes on the liquid crystal panel, and these adjustments require time. In addition, these electrodes are extremely fine, and a defective product may also be produced because of a failure in the fine adjustment. However, at present, no technique has been proposed for simplifying the positioning of the electrodes of the liquid crystal panel and the COF electrodes.

### SUMMARY OF THE INVENTION

It is a principal object of the present invention to provide a liquid crystal display apparatus and a method for manufacturing the liquid crystal display apparatus in which superposition of the electrodes of the liquid crystal panel and the COF electrodes can be performed simply.

According to a first aspect of the invention, a liquid crystal display apparatus including: a liquid crystal panel including an electrode portion where a plurality of electrodes are arranged in a row; and a COF substrate including a COF electrode portion where a plurality of COF electrodes are arranged in a row, which COF electrodes have widths different from widths of the electrodes, wherein at least one of the COF electrodes in the COF electrode portion is a positioning electrode for carrying out superposition of the electrodes and the COF electrodes, which positioning electrode has a shape different from shapes of other COF electrodes, and a width of the positioning electrode and an interval between the COF electrodes are set so that, when at least one end portion in a width direction of the positioning electrode and at least one end portion in a width direction of one electrode in the electrode portion are aligned, a center in a width direction of each of the other COF electrodes and a center in a width direction of each of the electrodes are substantially align.

According to a second aspect of the invention, a liquid crystal display apparatus including: a liquid crystal panel including an electrode portion where a plurality of electrodes are arranged in a row; and a COF substrate including a COF electrode portion where a plurality of COF electrodes are arranged in a row, which COF electrodes have widths different from widths of the electrodes, wherein the COF electrodes at both sides of the COF electrode portion are positioning electrodes for carrying out superposition of the electrodes and the COF electrodes, which positioning electrodes have shapes different from shapes of other COF electrodes, widths of the positioning electrodes and an interval between the COF electrodes are set so that, when at least one end portion in a width direction of the positioning electrodes and at least one end portion in a width direction of the one electrode in the electrode portion are aligned, a center in a width direction of each of the other COF electrodes and a center in a width direction of each of the electrodes are substantially align, and the positioning electrodes are dummy electrodes.

According to a third aspect of the invention, a method for manufacturing the above liquid crystal display apparatus, the method including a step of: carrying out positioning by allowing one end portion in a width direction of the positioning electrode positioned at one end of the COF electrode portion and one end portion in a width direction of one electrode in the electrode portion, which one electrode corresponds to the positioning electrode, to be align.

### BRIEF DESCRIPTION OF THE DRAWINGS

The above and other objects, advantages and features of the present invention will become more fully understood from the detailed description given hereinbelow and the appended drawings which are given by way of illustration only, and thus are not intended as a definition of the limits of the present invention, and wherein:
FIG. 1 is a plan view showing an overall structure of a liquid crystal display apparatus according to the embodiment;
FIG. 2A is a plan view showing details of an electrode portion of a liquid crystal panel and a COF electrode portion of a COF substrate;
FIG. 2B is an enlarged view of a frame portion A of FIG. 2A;
FIG. 3 is a view for explaining an adhesion method between the COF substrate and the liquid crystal panel;
FIG. 4A is a plan view showing the state in which the electrode portion of the liquid crystal panel and the COF electrode portion of the COF substrate are superposed;
FIG. 4B is an enlarged view of a framed portion B of FIG. 4A;
FIG. 5 is a view showing variation of the COF electrode portion; and
FIG. 6 is a view for explaining superposition of the electrodes of the crystal panel and the COF electrode.

### DETAILED DESCRIPTION OF THE PREFERRED EMBODIMENTS

The embodiment of the present invention will be explained below with reference to the drawings.

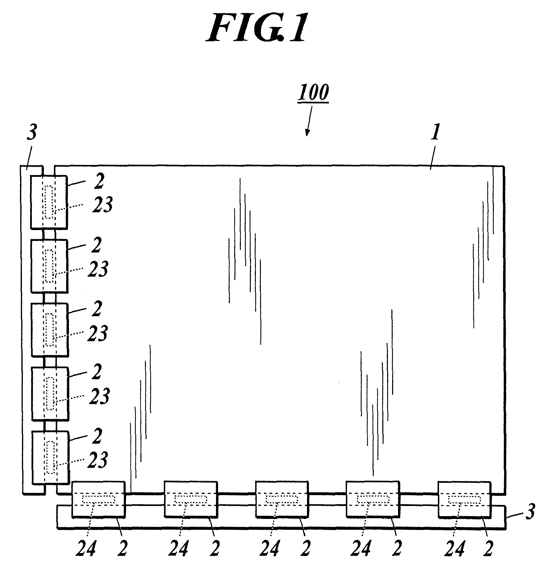

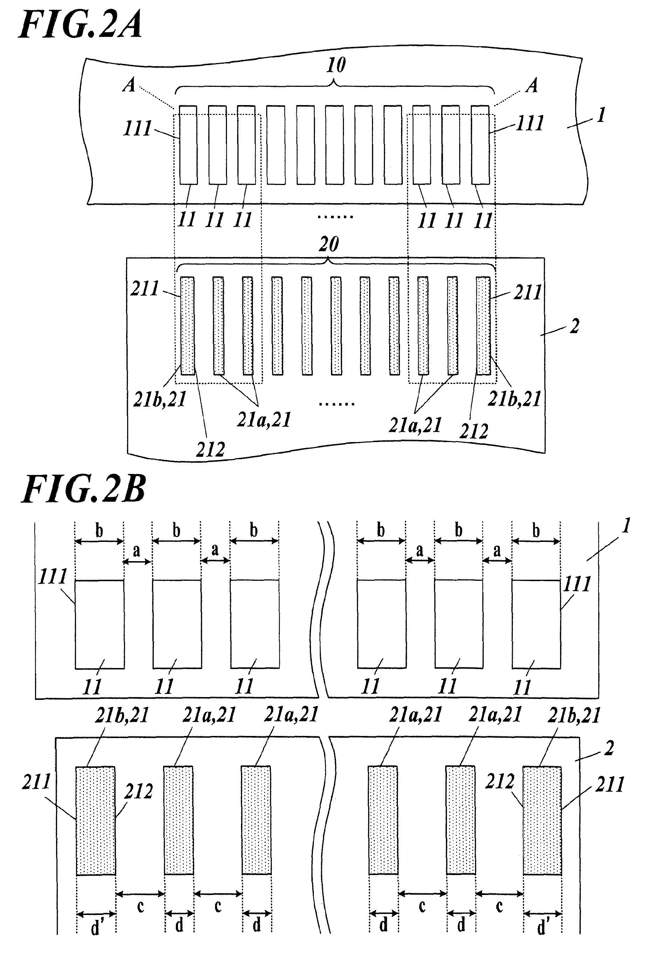

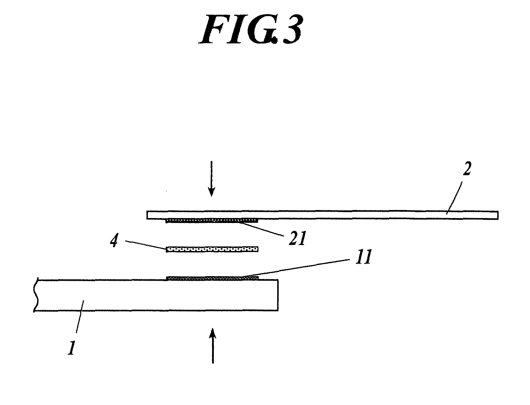

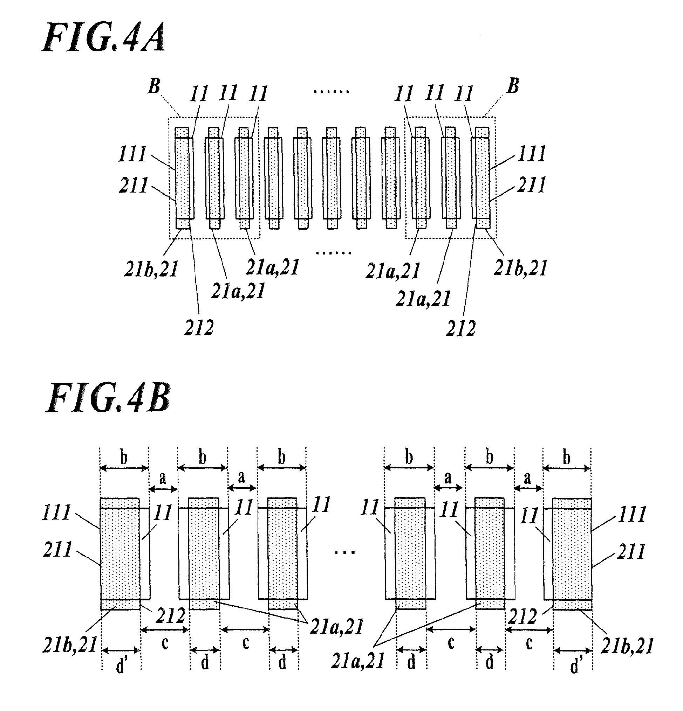

FIG. 1 is a plan view showing an overall structure of a liquid crystal display apparatus of the embodiment of the present invention. FIG. 2A is a plan view showing details of an electrode portion of a liquid crystal panel and a COF electrode portion of a COF substrate. FIG. 2B is an enlarged view of a frame portion A of FIG. 2A. FIG. 3 is a view for explaining an adhesion method applied to the COF substrate and the liquid crystal panel. FIG. 4A is a plan view showing the state in which the electrode portion of the liquid crystal panel and the COF electrode portion of the COF substrate are superposed, and FIG. 4B is an enlarged view of a framed portion B of FIG. 4A. Note that the scope of the present invention is not limited to the illustrated embodiment.

As shown in FIG. 1, a liquid crystal display apparatus 100 of the embodiment is composed of a liquid crystal panel 1 in which liquid crystal cells and transparent electrodes are formed on a glass substrate; COF substrates 2 on each of which a gate driver 23 or source driver 24 to drive the liquid crystal panel 1 is formed; and printed circuit boards (PCB) 3 on which circuits and wiring are formed for supplying electrical source voltages and various types of signals to the gate drivers 23 and the source drivers 24.

In this structure, the COF substrates 2 and the liquid crystal panel 1, and the COF substrates 2 and the printed circuit boards 3 are mechanically and electrically connected by adhering the electrodes thereof to each other with an anisotropic conductive film (ACF) 4 interposed therebetween.

As shown in FIG. 2A and FIG. 2B, in proximity to the edge of the liquid crystal panel 1, there is provided a plurality of electrode portions 10 where a plurality of vertically elongated fine electrodes 11 are formed, and the electrodes 11 are arrayed in a row at equal intervals a. On the other hand, in proximity to the edge of the COF substrates 2, there is provided a COF electrode portion 20 where a number of vertically elongated fine COF electrodes 21 are formed, and the COF electrodes 21 are arrayed in a row at equal intervals c.

The electrodes 11 of the liquid crystal panel 1 and the COF electrodes 21 of the COF substrate 2 are disposed so as to be superposed on each other in a 1-to-1 arrangement when the COF substrate 2 and the liquid crystal panel 1 are connected to each other. Specifically, as shown in FIG. 3, when connecting the liquid crystal panel 1 to the COF substrate 2, they are compression-bonded by aligning the electrodes 11 of the liquid crystal panel 1 and the COF electrodes 21 so as to face each other in a 1-to-1 arrangement, and then pushing the electrodes together while an anisotropic conductive film 4 is inserted therebetween.

A length of the electrodes 11 of the liquid crystal panel 1 in a width direction (hereinafter the length in a width direction is referred to as the "electrode width") and the electrode width of the COF electrodes 21 are different, and in the embodiment, the electrode width d of the COF electrodes 21 is formed so as to be narrower than the electrode width b of the electrodes 11.

In addition, among the COF electrodes 21 formed on the COF substrate 2, two COF electrodes 21b disposed at both ends have the electrode widths d' which is wider than the electrode widths d of the COF electrodes (the other COF electrodes) 21a disposed on the center side of the COF electrode portion 20 by an amount equivalent to d' - d ((b - d)/2). The two COF electrodes 21 positioned at both ends of the COF electrode portion 20 are positioning electrodes to be collimating marks for positioning when superposition of the electrodes 11 of the liquid crystal panel 1 and the COF electrodes 21. In addition, these positioning electrodes 21b are dummy electrodes, and their use is limited to positioning.

The widths d' of the positioning electrodes 21b, the widths d of the other COF electrodes 21, and the intervals c between the COF electrodes 21 (21a, 21b) described above respectively are set, according to the electrode widths b of the electrodes 11 of the liquid crystal panel 1 and the intervals a between the electrodes 11, so that when one end portion 211 in a width direction of the positioning electrodes 21b and one end portion 111 in a width direction of the one electrode 11 in the electrode portion 10 are aligned, the center in a width direction of the electrodes 11 of the liquid crystal panel 1 and the center in a width direction of the COF electrodes 21a (COF electrodes (other COF electrodes) other than positioning electrodes 21b disposed at both ends of the COF electrode portions 20) disposed on the center side of the COF electrode portions 20 are substantially align.

Specifically, during superposition of the electrodes 11 of the liquid crystal panel 1 and the COF electrodes 21, any one end portion (for example, the one end portion 211 in the outward direction) in a width direction of the positioning electrodes 21b disposed at both ends of the COF electrode portion 20 is allowed to correspond to one end portion (for example, the one end portion 111 in the outward direction) in a width direction of the corresponding electrodes 11 in the electrode portion 10. Thus, as shown in FIGS. 4A and 4B, the centers in a width direction of the COF electrodes 21a disposed on the center side of the COF electrode portion 20 are substantially superposed on the centers in a width direction of the electrodes 11 of the liquid crystal panel 1. Therefore, during the positioning operation, if the one end portion 211 outside in a width direction of the COF electrodes 21 disposed on both sides of the COF electrode portion 20 is disposed so as to be aligned with the one end portion 111 outside in a width direction of the electrodes 11 of the liquid crystal panel 1, then the electrodes 11 of the liquid crystal panel 1 and the COF electrodes 21 (21a and 21b) are correctly superposed in a 1-to-1 arrangement.

In addition, while the electrodes 11 of the liquid crystal panel 1 and the COF electrodes 21 are superposed, by confirming whether or not the one end portion (for example, the one end portion 211 in the outside direction) in a width direction of the other positioning electrode 21b and one end portion (for example, the one end portion 111 in the outside direction), in a width direction of the corresponding electrode 11 in the electrode portion 10 are aligned, it is possible to confirm reliably that superposition of the electrodes 11 of the liquid crystal panel 1 and the COF electrodes 21 has been correctly carried out.

According to the liquid crystal display apparatus 100 of the embodiment explained above, the apparatus 100 is equipped with the liquid crystal panel 1 including the electrode portion 10 where a plurality of the electrodes are arranged in a row; and the COF substrate 2 including the COF electrode portion 20 where a plurality of the COF electrodes 21 (21a and 21b) are arrayed in a row and have widths different from widths of the electrodes 11, and wherein the COF electrodes 21b in the COF electrode portion 20 are used as positioning electrodes when carrying out superposition of the electrodes 11 and the COF electrodes 21, and have a shape that is different from that of the other COF electrodes 21a. Moreover, the widths of the positioning electrodes 21b and the intervals between the COF electrodes 21 are set such that the center in a width direction of the other COF electrodes 21 and the center in a width direction of the electrodes 11 are substantially superposed when the one end portion 211 in a width direction of a positioning electrode 21b and the one end portion 111 in a width direction of one electrode 11 in the electrode portion 10 are aligned.

Therefore, when superposition of the electrodes 11 of the liquid crystal panel 1 and the COF electrodes 21 of the COF substrate 2, simply by aligning the one end portion 211 of the COF electrodes 21b, which are the positioning electrodes, with the one end portion 111 of the corresponding electrodes 11 in the electrode portion 10, the center in a width direction of the other COF electrodes 21 and the center in a width direction of the electrodes 11 of the liquid crystal panel 1 are substantially superposed, and superposition of the electrodes 11 of the liquid crystal panel 1 and the COF electrodes 21 can thereby be easily carried out.

Moreover, in the case in which the positioning electrode is a COF electrode 21b at one end of the COF electrode portion 20, because the positioning electrode is disposed at the end, superposition of the electrodes 11 of the liquid crystal panel 1 and the COF electrodes 21 becomes even easier.

Moreover, in the case in which the positioning electrodes are the COF electrodes 21b at both ends in the COF electrode portion 20, it is possible to confirm reliably whether or not superposition of the electrodes 11 of the liquid crystal panel 1 and the COF electrodes 21 has been correctly carried out by confirming, while the electrodes 11 of the liquid crystal panel 1 and the COF electrodes 21 are superposed based on one of the positioning electrodes 21b, whether or not the one end portion of the other positioning electrode 21b and the one end portion of the corresponding electrode 11 in the electrode portion 10 are aligned.

Furthermore, because the positioning electrodes 21b are dummy electrodes, even when the dimensions and properties of the positioning electrodes change due to the superposing step of the electrodes 11 of the liquid crystal panel 1 and the COF electrodes 21, this does not adversely influence the liquid crystal display apparatus.

Note that the scope of the present invention is not limited to the above embodiment, and that various improvements and modifications of the design are possible within a range that does not depart from the spirit of the present invention.

For example, in the embodiment described above, a case is explained in which the electrode width of the COF electrodes 21 is narrower than the electrode width of the electrodes 11 of the liquid crystal panel 1. However, the electrode width of the COF electrodes 21 may be formed so as to be wider than the electrode width of the electrodes 11 of the liquid crystal panel 1.

Moreover, in the embodiment described above, a structure is used in which the electrode width d' of the positioning electrodes 21b is formed so as to be narrower than the electrode width b of the electrodes 11 of the liquid crystal panel 1. However, the electrode width of the positioning electrodes 21b and the electrode width of the electrodes 11 of the liquid crystal panel 1 can be made identical widths, and in the superposing step of the electrodes 11 of the liquid crystal panel 1 and the COF electrodes 21, positioning may be carried out by aligning both end portions in a width direction of the positioning electrodes and both end portions in a width direction of one electrode 11 in the liquid crystal panel 1. In this case, only the intervals between the positioning electrodes 21b and the adjacent COF electrode 21 are set so as to be smaller than the intervals between the other COF electrodes 21.

Moreover, though the positioning electrodes 21b are dummy electrodes in the embodiment described above, the positioning electrodes 21b do not need to be dummy electrodes. In this case, the present invention can be formed without providing a new structure for the positioning.

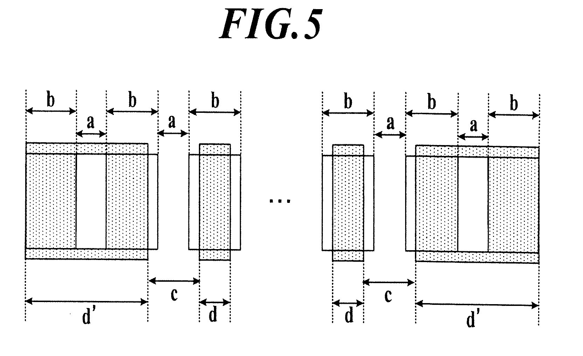

Furthermore, for example, as shown in FIG. 5, an arrangement may be provided in which two COF electrodes are connected and a slit is interposed therebetween, which slit has a width identical to the width between the electrodes 11 of the liquid crystal panel 1. Then, during the superposing step for the electrodes 11 of the liquid crystal 1 and the COF electrodes, when positioning is carried out such that the slit of the positioning electrode is disposed between the electrodes 11 of the liquid crystal panel 1, the center in a width direction of the other COF electrodes and the center in a width direction of the electrodes 11 are substantially superposed, and superposition can thereby be accurately carried out.

According to a first aspect of the preferred embodiment of the present invention, there is provided a liquid crystal display apparatus including: a liquid crystal panel including an electrode portion where a plurality of electrodes are arranged in a row; and a COF substrate including a COF electrode portion where a plurality of COF electrodes are arranged in a row, which COF electrodes have widths different from widths of the electrodes, wherein at least one of the COF electrodes in the COF electrode portion is a positioning electrode for carrying out superposition of the electrodes and the COF electrodes, which positioning electrode has a shape different from shapes of other COF electrodes, and a width of the positioning electrode and an interval between the COF electrodes are set so that, when at least one end portion in a width direction of the positioning electrode and at least one end portion in a width direction of one electrode in the electrode portion are aligned, a center in a width direction of each of the other COF electrodes and a center in a width direction of each of the electrodes are substantially align.

Preferably, the positioning electrode is the COF electrode at one end of the COF electrode portion.

Preferably, the positioning electrodes are the COF electrodes at both ends of the COF electrode portion.

Preferably, the positioning electrode is a dummy electrode.

According to a second aspect of the preferred embodiment of the present invention, there is provided a liquid crystal display apparatus including: a liquid crystal panel including an electrode portion where a plurality of electrodes are arranged in a row; and a COF substrate including a COF electrode portion where a plurality of COF electrodes are arranged in a row, which COF electrodes have widths different from widths of the electrodes, wherein the COF electrodes at both sides of the COF electrode portion are positioning electrodes for carrying out superposition of the electrodes and the COF electrodes, which positioning electrodes have shapes different from shapes of other COF electrodes, widths of the positioning electrodes and an interval between the COF electrodes are set so that, when at least one end portion in a width direction of the positioning electrodes and at least one end portion in a width direction of the one electrode in the electrode portion are aligned, a center in a width direction of each of the other COF electrodes and a center in a width direction of each of the electrodes are substantially align, and the positioning electrodes are dummy electrodes.

According to a third aspect of the preferred embodiment of the present invention, there is provided a method for manufacturing the above liquid crystal display apparatus, the method including a step of: carrying out positioning by allowing one end portion in a width direction of the positioning electrode positioned at one end of the COF electrode portion and one end portion in a width direction of one electrode in the electrode portion, which one electrode corresponds to the positioning electrode, to be align.

According to the present invention, the liquid crystal display apparatus is equipped with the liquid crystal panel including the electrode portion where a plurality of the electrodes are arranged in a row; and the COF substrate including the COF electrode portion where a plurality of the COF electrodes are arrayed in a row and have widths different from widths of the electrodes, and wherein at least one of the COF electrodes in the COF electrode portion is used as the positioning electrode when carrying out superposition of the electrodes and the COF electrodes, and have a shape different from that of the other COF electrodes. Moreover, the width of the positioning electrode and the interval between the COF electrodes are set such that the center in a width direction of the other electrodes and the center in a width direction of the electrodes are substantially superposed when at least the one end portion in a width direction of a positioning electrode and at least the one end portion in a width direction of one electrode in the electrode portion are aligned.

Therefore, when superposition of the electrodes of the liquid crystal panel and the COF electrodes of the COF substrate, simply by aligning at least the one end portion of the COF electrode as the positioning electrode with the one end portion of the corresponding electrode in the electrode portion, the center in a width direction of the other COF electrodes and the center in a width direction of the electrodes of the liquid crystal panel are substantially superposed, and superposition of the electrodes 11 of the liquid crystal panel 1 and the COF electrodes 21 can thereby be easily carried out.

## Claims

1. A liquid crystal display apparatus comprising:
a liquid crystal panel including an electrode portion where a plurality of electrodes are arranged in a row; and
a COF substrate including a COF electrode portion where a plurality of COF electrodes are arranged in a row, which COF electrodes have widths different from widths of the electrodes, wherein
at least one of the COF electrodes in the COF electrode portion is a positioning electrode for carrying out superposition of the electrodes and the COF electrodes, which positioning electrode has a shape different from shapes of other COF electrodes, and
a width of the positioning electrode and an interval between the COF electrodes are set so that, when at least one end portion in a width direction of the positioning electrode and at least one end portion in a width direction of one electrode in the electrode portion are aligned, a center in a width direction of each of the other COF electrodes and a center in a width direction of each of the electrodes are substantially align.

2. The liquid crystal display apparatus according to claim 1, wherein the positioning electrode is the COF electrode at one end of the COF electrode portion.

3. The liquid crystal display apparatus according to claim 1, wherein the positioning electrodes are the COF electrodes at both ends of the COF electrode portion.

4. The liquid crystal display apparatus according to any of claims 1-3, wherein the positioning electrode is a dummy electrode.

5. A liquid crystal display apparatus comprising:
a liquid crystal panel including an electrode portion where a plurality of electrodes are arranged in a row; and
a COF substrate including a COF electrode portion where a plurality of COF electrodes are arranged in a row, which COF electrodes have widths different from widths of the electrodes, wherein
the COF electrodes at both sides of the COF electrode portion are positioning electrodes for carrying out superposition of the electrodes and the COF electrodes, which positioning electrodes have shapes different from shapes of other COF electrodes,
widths of the positioning electrodes and an interval between the COF electrodes are set so that, when at least one end portion in a width direction of the positioning electrodes and at least one end portion in a width direction of the one electrode in the electrode portion are aligned, a center in a width direction of each of the other COF electrodes and a center in a width direction of each of the electrodes are substantially align, and
the positioning electrodes are dummy electrodes.

6. A method for manufacturing the liquid crystal display apparatus according to claim 2, the method comprising a step of:
carrying out positioning by allowing one end portion in a width direction of the positioning electrode positioned at one end of the COF electrode portion and one end portion in a width direction of one electrode in the electrode portion, which one electrode corresponds to the positioning electrode, to be align.
